# EUROPEAN PATENT SPECIFICATION

(11) **EP 4 246 685 B1**
(45) Date of publication and mention of the grant of the patent: **29.07.2026**
(21) Application number: 22887465.7
(22) Date of filing: 18.10.2022
(51) Int. Cl.: H01M 50/213, H01M 50/291, H01M 50/24, H01M 50/502, H01M 10/48, H01M 10/42, H01M 10/6572, H01M 10/613

(54) **CELL TRAY**
ZELLENSCHALE
PLATEAU DE CELLULES

(30) Priority: 26.10.2021 KR 20210143958
(43) Date of publication of application: 20.09.2023
(73) Proprietor: LG Energy Solution, Ltd., Seoul 07335 (KR)
(72) Inventor: SONG, Hyeon Jin, Daejeon 34122 (KR)
(74) Representative: Goddar, Heinz J.
(86) International application number: PCT/KR2022/015883
(87) International publication number: WO 2023/075269

(56) References cited:
- WO-A1-2014/107094
- WO-A1-2020/215284
- CN-B- 103 985 831
- JP-B2- 6 694 687
- KR-A- 20100 100 943
- KR-A- 20100 100 943
- KR-A- 20170 093 889
- KR-A- 20180 064 485
- KR-A- 20180 099 438
- KR-A- 20210 025 293
- US-A1- 2021 028 431

## Description

### [Technical Field]

The present invention relates to a cell tray, and more specifically, a cell tray for accommodating or storing cylindrical cells in a charge/discharge process for activation or an aging process, or for transporting the cylindrical cells between each process.

### [Background Technology of the Invention]

As technology development and demand for mobiles, automobiles, and energy storage device fields increase, the demand for battery as an energy source is rapidly increasing, and among these secondary batteries, a lot of research has been done on lithium secondary batteries which have high energy density and high discharge voltage, and they are also widely used by being commercialized.

In particular, lithium secondary batteries are showing a rapidly growing trend by having an operating voltage of 3.6V or higher, three times higher than nickel-cadmium batteries or nickel-hydrogen batteries, which are widely used as power sources for portable electronic devices, and having a high energy density per unit weight.

Meanwhile, a lithium secondary battery is manufactured through a process of assembling a cell and activating the battery, and in the battery activation stage, the battery is loaded on a tray and is charged and discharged under conditions necessary for activation.

The lithium secondary battery can be classified into a stack type battery, a pouch type battery, and a cylindrical battery depending on its structure and shape.

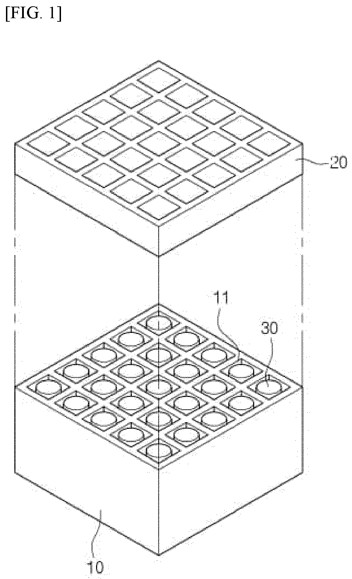

FIG. 1 shows a conventional tray accommodating multiple cylindrical cells. Referring to FIG. 1, there is a main body 10 having a battery accommodating part 11 capable of individually accommodating multiple cylindrical cells 30 and having an open top, and a cover 20 covering the upper part of the main body 10 to protect the accommodated cells 30.

As such, because the conventional tray only achieves the function of simply receiving or transporting the cylindrical cells, it was unable to monitor the characteristics or status of the cells during each process or while moving between processes. For example, during the initial charge/discharge process, the voltage during charge/discharge can be measured by connecting the terminal of the charge/discharger to the lead of the cell accommodated in the tray, but the voltage of the cell while moving between processes or during storage cannot be measured. In addition, due to the nature of the charge/discharge process, it was difficult to measure other electrical characteristics such as impedance, other than voltage. Cells before and after activation process or aging process are in a state where electrical characteristics such as voltage, impedance, and current may change over time as their electrical characteristics have not yet been established, so it is necessary to continuously monitor the changes of their electrical characteristics.

Meanwhile, heat may be generated in the process of performing each process in the cells accommodated in the tray, and given the characteristics of the tray, which mostly has a closed structure, the cells accommodated in the tray are often placed in a heat-generating environment that affects the cell performance. Therefore, there is a demand for a structure that can continuously monitor changes in the electrical characteristics of the accommodated cells, as well as a cell tray that can effectively control the heat generated from the accommodated cells.

WO 2020/215284 A1 describes a camera device having a housing that is provided with a battery compartment for a single battery cell, already for space constraints.

KR 2018-0099438 A describes a frame assembly for fixing a plurality of stacked battery cells in a battery module. The frame assembly includes a frame, a plurality of bus bars, and a flexible circuit board. The flexible circuit board is disposed along the top and both sides of the frame and electrically connected to the plurality of bus bars to sense a plurality of battery cells. The terminals of the battery cells comprise tabs made of a conductive and deformable material that pass through openings formed in the bus bars and openings formed in the frame before being bent so as to come into contact with the front surfaces of the bus bars.

### [Related Art]

Korean Patent Publication No. 10-2019-0094830

### [Description of the Invention]

### [Technical Problem]

The present invention is directed to solve above-mentioned problems, and it is directed to provide a cell tray that can measure and monitor electrical characteristics of a cylindrical cell in a charge/discharge process, transfer between processes, aging process, etc.

Also, the present invention is directed to provide the cell tray to solve the problem when the cylindrical cells stored in the cell tray are damaged by heat generated in the process of measuring electrical characteristics, or when the performance of the cell is degraded.

### [Technical Solution]

According to the present invention, the cell tray includes: a tray body in which upper part is open and having an internal space, partition walls diving the internal space so that a plurality of cylindrical cells are each accommodated between the partition walls; a first connector pivotably installed on an upper part of a first partition wall of the partition walls and pivoting toward an upper electrode tab to contact an upper electrode tab of a first cylindrical cell of the plurality of cylindrical cells; a second connector installed in the tray body between the partition walls and contacting a lower electrode tab of the first cylindrical cell; and an electrical characteristic measurer that is electrically connected to the first connector and the second connector to measure an electrical characteristic of the first cylindrical cell.

Specifically, the partition walls may be formed in a lattice shape.

In addition, the tray body may contain a bottom plate forming a lower part of the tray body, the partition walls installed on the bottom plate, and an outer frame surrounding the partition walls and coupled to the bottom plate or integrally formed with the bottom plate.

In addition, a height of the outer frame may be greater than a combined height of the partition walls and a length of the first connector.

Meanwhile, a hinge frame is installed on the upper part of the first partition wall, and the first connector may be hinge combined to the hinge frame.

The electrical characteristic measurer can measure at least one of electrical resistance, voltage, and current of the first cylindrical cell.

Meanwhile, a wireless communication device may be connected to the electrical characteristic measurer, and capable of transmitting an electrical characteristic value of the first cylindrical cell measured by the electrical characteristic measurer to outside the tray body.

In addition, a cooling member for cooling the cylindrical cell may on the bottom plate of the tray body.

Specifically, a cooling member accommodating groove is formed in the bottom plate, thereby the cooling member is installed in the cooling member accommodating groove, and the second connector may be installed on the cooling member.

More specifically, the cooling member may be a thermoelectric module.

According to one exemplary embodiment, a tray top coupled to the tray body to cover the upper part of the tray body may be additionally included.
Specifically, the tray top may include an insulating member protruding downward at a position corresponding to the first cylindrical cell.
Meanwhile, the electrical characteristic measurer may be installed either on the tray body or on the tray top.

Meanwhile, a third connector may be hinged to the hinge frame, and the third connector may contact an upper electrode tab of a second cylindrical cell of the plurality of cylindrical cells.

According to another exemplary embodiment, the partition walls may be formed in a lattice shape, and the hinge frame may have a third connector, a fourth connector and a fifth connector respectively contacting a second battery cell, a third battery cell and a fourth battery cell of the plurality of battery cells.

The hinge frame may be located at an intersection of the first partition wall and a second partition wall, and each of the connectors may extend diagonally from the intersection.

### [Advantageous Effects]

The present invention has an effect of easily monitoring electrical characteristics such as voltage and impedance current of a unidirectional battery cell during a charge/discharge process, aging process, or between each process.

Also, the present invention has an effect of solving the thermal stability problem of the cell by effectively controlling the heat generated from multiple cylindrical cells stored on the inside.

### [Brief Description of the Drawings]

FIG. 1 shows a conventional cylindrical cell tray.
FIG. 2 is a cross-sectional view and a plan view of a cell tray according to the first exemplary embodiment of the present invention.
FIG. 3 shows a hinge member and a first lead connector included in the cell tray according to the first exemplary embodiment of the present invention.
FIG. 4 shows the configuration of a tray body and a tray top included in the cell tray according to the first exemplary embodiment of the present invention.
FIG. 5 shows the hinge member and the first lead connector included in the cell tray according to the second exemplary embodiment of the present invention.
FIG. 6 is a cross-sectional view and a plan view of a cell tray according to the second exemplary embodiment of the present invention.

### [Best Mode for Carrying Out the invention]

Hereinafter, a detailed configuration of the present invention will be described in detail with reference to the accompanying drawings and various embodiments. The embodiments described below are shown by way of an example to aid understanding of the present invention, and the accompanying drawings are not drawn to scale in order to aid understanding of the present invention, and the dimensions of some of the components may be exaggerated.

Since the present invention can make various changes and can take various forms, specific embodiments are illustrated in the drawings and described in detail in the specification. However, it is not intended to limit the present invention to a specific disclosed form, and it should be understood to include all modifications, equivalents, or substitutes included in the technical scope of the present invention.

The present invention relates to a cell tray 100 accommodating multiple cylindrical cells C each in which two electrode tabs are respectively formed on the upper part and the lower part.

The cell tray 100 of the present invention includes: a tray body 110 that accommodates multiple cylindrical cells C, has an open upper part, and has a partitioning wall 111 diving the internal space so that multiple cylindrical cells C are each accommodated between the partition walls 111, a first connector 131 pivotably installed on an upper part of the partition wall 111 and pivoting toward the upper electrode tab so as to come into contact with the upper electrode tab of the cylindrical cell C accommodated between the partition walls 111, a second connector 132 installed in the tray body between the partition walls 111 and comes into contact with the lower electrode tab of the cylindrical cell accommodated between the partition walls 111, and an electrical characteristic measuring device 140 that is electrically connected to the first connector 131 and the second connector 132 to measure the electrical characteristics of the cylindrical cell C.

The tray body 110 includes a bottom plate 113 on which the cylindrical cells C are settled, a lattice-type partition wall 111 in which the cylindrical cells C are accommodated and which is installed on the bottom plate 113, and an outer frame 112 surrounding the partition wall 111.

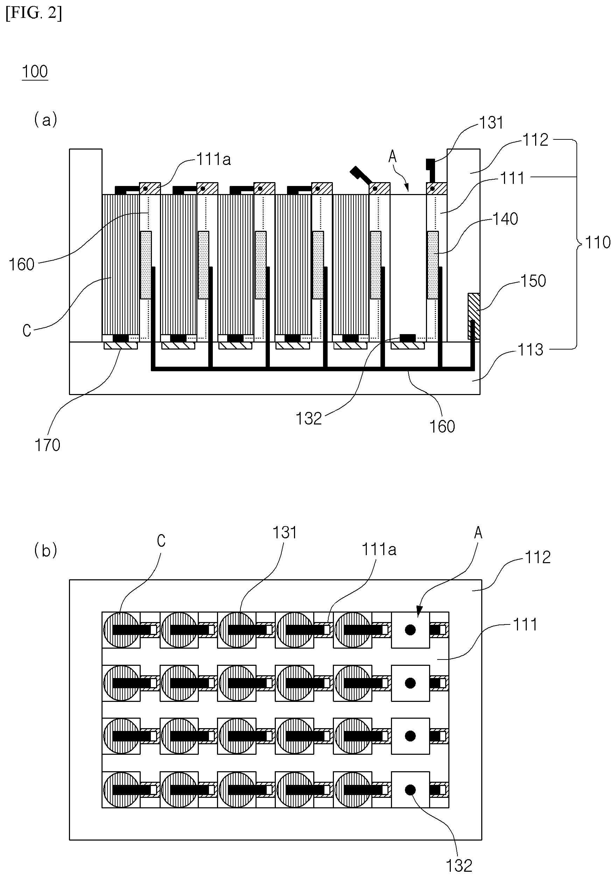

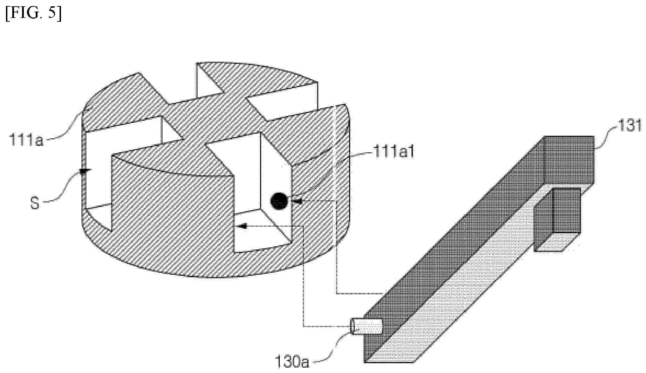

FIG. 2 through FIG. 4 show the configuration of the cell tray 100 according to the first exemplary embodiment of the present invention, and FIG. 5 through FIG. 6 show the configuration of the cell tray 100 according to the second exemplary embodiment of the present invention.

Hereinafter, the configuration and function of the cell tray 100 of the present invention will be described with reference to the drawings.

### [Mode for Carrying Out the invention]

### (First Embodiment)

The basic structure of the cell tray 100 of the present invention is almost the same as that of FIG. 1 referred to in the background art. However, additional configurations have been added to the cell tray 100 of the present invention to continuously monitor the trend of the electrical characteristics of the cylindrical cells C accommodated in the existing structure.

Specifically, the cell tray 100 of the present invention includes connectors that can be electrically connected by being in contact with the electrode tabs formed on the top and bottom of the cell in order to determine the electrical characteristics of each of the accommodated cylindrical cells C. It will be described with reference to FIG. 2 through FIG. 4.

FIG. 2 is a cross-sectional view (FIG. 2(a)) and a plan view (FIG. 2(b)) of the cell tray 100 according to the first exemplary embodiment of the present invention.

Referring to FIG. 2, the cell tray 100 of the present invention is composed of a tray body 110 including a partition wall 111 formed so that multiple cylindrical cells C can be accommodated separately, an outer frame 112 that surrounds and supports the side surface so as to surround all the cylindrical cells C accommodated in the accommodating part A formed by the partition wall 111, and a bottom plate 113 coupled to the lower part of the partition wall 111 and the outer frame 112 to support the lower part of the accommodated cylindrical cells C.

The tray body 110 of the present invention includes the partition wall 111 forming the accommodating part A in which the cylindrical cells C are accommodated.

The partition wall 111 is designed in a lattice shape so that the cylindrical cells C can be separately accommodated in the tray body 110 one by one, and includes multiple accommodating parts A formed by the lattice structure.

As illustrated in FIG. 2(b), the partition wall 111 is designed in a lattice shape, and the partition wall 111 supports the side part of the cylindrical cell C accommodated in the accommodating part A. If necessary, some of the side surfaces of some cylindrical cells C accommodated in the outermost part may be supported by the outer frame 112.

The partition wall 111 may further include a hinge frame 111a that can be coupled to a first connector 131 to be described later. Specifically, the hinge frame 111a may be installed on the upper part of the partition wall 111.

The hinge frame 111a may be hinged to multiple first connectors 131 that rotate toward the upper electrode tabs of the cylindrical cells C located in front and rear, left and right, or front, rear, left, and right of the partition wall 111.

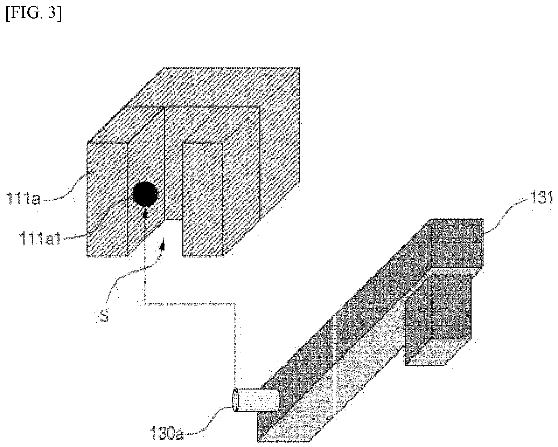

The hinge frame 111a will be discussed again later when describing the first connector 131 with reference to FIG. 3 and the like.

The tray body 110 of the present invention includes an outer frame 112 surrounding the partition wall 111.

The outer frame 112 supports the partition wall 111 and the accommodated cylindrical cells C in a shape of surrounding them entirely, and serves to protect the cylindrical cells C from the outside.

The height of the outer frame 112 may be higher than the height of the partition wall 111, and the outer frame may be preferably formed higher than the height of the partition wall by a height exceeding the rotation radius of the first connector.

The tray body 110 of the present invention includes a bottom plate 113 on which the cylindrical cells C are settled.

The bottom plate 113 is coupled to the lower surfaces of the partition wall 111 and the outer frame 112 and serves to support the partition wall 111 and the outer frame 112 from below. In addition, the bottom plate 113 supports the lower part of the accommodated cylindrical cells C.

The partition wall 111, the outer frame 112, and the bottom plate 113 may be designed as an integral type, or may be designed as a separate type if necessary, and the present invention is not particularly limited thereto.

The cell tray 100 of the present invention includes connectors electrically connected to electrode tabs formed on both sides of the accommodated cylindrical cells C. The connectors may be made of an electrically conductive metal material, such as copper. Specifically, the connectors include a first connector 131 installed on the upper part of the partition wall 111 and a second connector 132 installed on the bottom plate 113.

The first connector 131 is installed on the upper part of the partition wall 111 and contacts the upper electrode tab of the cylindrical cell C. Specifically, the first connector 131 is formed by being hinged to the upper part of the partition wall 111.

The first connector 131 may have a hinge shaft hinged to the hinge frame 111a. Specifically, it can be seen that the first connector 131 is hinged to the hinge frame 111a located on the upper part of the partition wall 111, and that the hinge rotates starting from the hinge shaft 130a. The hinge rotation of the first connector 131 as described above is to avoid interfering with the entry and exit of the cylindrical cell C to the accommodating part A.

When the first connector 131 hinge rotates upward starting from the hinge shaft 130a, it opens the entrance of the accommodating part A and allows entry and exit of the cylindrical cell C, but when the first connector 131 hinge rotates downward starting from the hinge shaft 130a, the first connector 131 structurally blocks the entrance of the accommodating part A, making it impossible for the cylindrical cell C to enter and exit. Although not shown in the drawing, if the first connector 131 hinges downward when the cylindrical cell C is accommodated in the cell tray 100, the upper electrode tab of the cylindrical cell C and the front end of the first connector 131 come into contact so that electrical connection becomes possible. Conversely, if the first connector 131 hinges upward, the first connector 131 gets separated from the upper electrode tab of the cylindrical cell C, making electrical connection impossible.

FIG. 3 shows the hinge frame 111a and the first connector 131 included in the cell tray 100 according to the first exemplary embodiment of the present invention.

Referring to FIG. 3, it can be seen that the hinge shaft 130a is formed on the rear end of both ends of the first connector 131, and that the front end has a shape protruding downward. The front end of the first connector 131 protrudes downward in order to effectively contact the electrode tab of the cylindrical cell C. However, the shape of the first connector 131 is not limited by the drawing, and even if the front end does not protrude downward, it is sufficient enough if it is in a shape that allows contact with the upper electrode tab of the cylindrical cell C.

The hinge frame 111a may include a connector insertion hole, which is a space where the first connector 131 is inserted. In addition, the hinge frame 111a may further include a groove 111a1 capable of engaging with the hinge shaft 130a of the first connector 131 when the first connector 131 is inserted into the connector insertion hole.

However, the shape of the hinge frame 111a does not need to be limited by FIG. 3, and any shape is possible as long as the first connector 131 is hinged at the upper part of the partition wall 111 and as long as it has a structure that can hinge rotate the first connector 131 so as not to interfere with the entry and exit of the cylindrical cell C.

When the first connector hinge rotates downward starting from the hinge shaft 130a, it comes into contact with the upper electrode tab of the accommodated cylindrical cell C, enabling electrical connection, and when the first connector 131 hinge rotates upward starting from the hinge shaft 130a, the electrical connection is lost.

The hinge frame 111a of the present invention maybe hinged with at least one first connector 131. The hinge frame 111a to which multiple first connectors 131 are connected will be discussed again later in the second embodiment of the present invention.

The second connector 132 is installed on the bottom plate 113 and contacts the lower part of the cylindrical cell C.

The second connecter 132 may be on top of the bottom plate 113. Specifically, since the second connector 132 needs to make electrical contact with the lower electrode tab of the cylindrical cell C accommodated in the accommodating part A, it is placed on top of the bottom plate 113 corresponding to the position of the accommodating part A.

The second connector 132 may protrude from the bottom plate 113, or it may be formed by being recessed into the bottom plate 113, and this will not be particularly limited to the present invention. However, it is sufficient enough to have a structure capable of being completely electrically connected to an electrode tab located in the lower part of the accommodated cylindrical cell C.

The cell tray 100 of the present invention includes an electrical characteristic measuring device 140 that measures the electrical characteristics of the cylindrical cell C by being electrically connected to the connector.

The electrical characteristic measuring device 140 is electrically connected to the first connector 131 and the second connector 132 through a conducting wire 160, and can measure at least one characteristic of the current, voltage, and resistance of the cylindrical cell C that is in contact with each of the connectors.

The electrical characteristic measuring device may be installed on the tray body 110.

Specifically, the electrical characteristic measuring device 140 may be installed on the partition wall 111, preferably installed in a form inserted into the partition wall 111 so that the entry and exit of the cylindrical cell C to the accommodating part A is not hindered.

The electrical characteristic measuring device 140 may transmit the measured characteristic value of the cylindrical cell C to the outside. Specifically, the present exemplary embodiment has a wireless communication device 150 connected to the electrical characteristic measuring device 140 installed on the tray body 110. As the wireless communication device 150, for example, an external NFC (Near Field Communication) tag acting as a reader and an NFC pad equipped with an NFC tag capable of wireless communication can be used. Alternatively, as the wireless communication device 150, an RFID tag capable of wireless communication with an external RFID (Radio Frequency Identification) reader can be used. However, the wireless communication device and wireless communication method are not limited to the above examples, and the wireless communication device of a different type can be used as long as it can effectively transmit the characteristic value of the cylindrical cell to the outside. Such wireless communication device 150 may transmit data transmitted from the electrical characteristic measuring device 140 to the outside by communicating with a receiving device outside the tray.

The wireless communication device 150 may be installed on the outer frame 112 included in the tray body 110 or the outer side of the bottom plate 113 to effectively transmit the electrical characteristics of the cylindrical cells C accommodated in the cell tray 100 to the outside.

A plurality of the wireless communication devices 150 corresponding to the number of cylindrical cells C may also be installed. In this case, each characteristic value may be derived from the wireless communication device 150 corresponding to each cell, and communication between the wireless communication devices 150 of each cell is also possible. Therefore, by installing a master wireless communication device 150 (e.g., a master NFC pad) that receives characteristic values from the wireless communication device 150 of each cell, the characteristic values of multiple cells can be collectively transmitted to the outside from the master wireless communication device 150. An external receiving device, for example, can be installed on a stacker crane that transfers the battery cell tray 100, and it is also possible to be installed on a storage rack of a warehouse where the battery cell tray 100 is stored.

The cell tray 100 of the present invention includes a cooling member 170 capable of cooling the cylindrical cells C and the cell tray 100 when the accommodated cylindrical cells C generate heat.

The cooling member 170 may preferably be a thermoelectric module or the like.

The cooling member 170, without using a refrigerant, can be substituted for any device that includes a function capable of cooling the accommodated cylindrical cells C as much as desired.

The cooling member 170 may be operated by receiving power from a separate power source (not shown) built into the tray body 110, or may be supplied with electricity by being electrically connected to the cylindrical cells C accommodated in the tray body 110.

The cooling member 170 does not require a separate refrigerant, and when electricity is being supplied, one side proceeds to absorb heat, and the other side opposite to the one side proceeds to release heat. Specifically, the cooling member 170 includes a heat absorbing part (not shown) for absorbing heat on one side, and a heat generating part (not shown) for releasing heat on the other side opposite to the one side. The cooling member 170 is preferably installed on the bottom plate 113 so that the one side including the heat absorbing part and the other side including the heat generating part can face the accommodating part A and the outside, respectively.

As illustrated in FIG. 2, it is desirable to have the cooling member 170 installed on the bottom plate 113 of the tray body 110. More specifically, the bottom plate 113 includes an accommodating groove (not shown), which is a space where the cooling member 170 can be installed, and the cooling member 170 may be installed by being inserted into the accommodating groove. Here, it is preferable to locate the second connector 132 on the cooling member 170. This allows one side of the bottom plate 113 to come into contact with all of the accommodated cylindrical cells C, so that the heat generated from the accommodating part A can be effectively absorbed, and it is a structure that can effectively discharge the absorbed heat to the outside.

Here, it is desirable for the cooling member 170 to have its one side that absorbs heat face the direction of the accommodating part A of the tray body 110, and have the other side that generates heat face the outward direction of the tray body 110.

The cell tray 100 of the present invention may additionally include a tray top 120 coupled to the tray body 110 while covering the opened upper part of the tray body 110 at the upper part of the tray body 110.

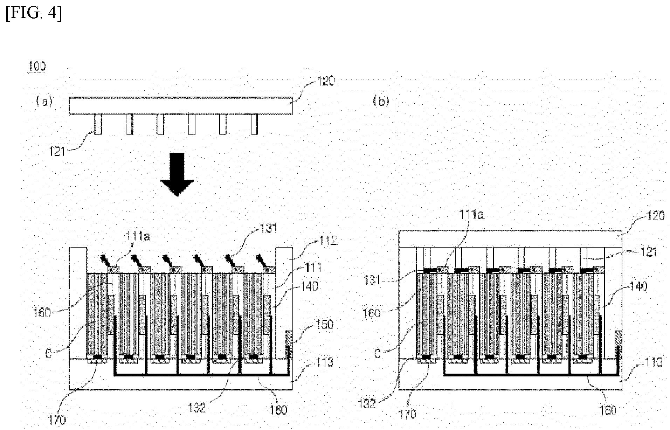

FIG. 4 shows the configuration of the tray body 110 and the tray top 120 included in the cell tray 100 according to the first exemplary embodiment of the present invention.

Referring to FIG. 4, the cell tray 100 of the present invention may further include a tray top 120 that coupled to the outer frame 112 included in the tray body 110 to cover the accommodated cylindrical cells C.

The cell tray 100 of the present invention can not only prevent foreign substances from mixing in to the tray body 110 by having the tray top 120, but it can also serve to pressurize so that the contact of the electrode tab of the first connector 131 and the cylindrical cell C can be stably made.

When the tray top 120 is coupled to the outer frame 112 at the upper part of the tray body 110, it can include an insulating member 121 that protrudes downward at a position corresponding to the cylindrical cells C accommodated in the tray body 110.

Referring to FIG. 4, it can be known that the insulating member 121 is preventing the electrical connection of the first connector 131 and the electrode tab from being disconnected by pressing the upper part of the first connector 131. In particular, even if the cell tray 100 receives an external shock while moving, the electrical connection of the first connector 131 and the electrode tab of the cylindrical cell C may be maintained due to the insulating member 121 of the tray top 120.

The tray top 120 may further include the electrical characteristic measuring device 140 if necessary.

### (Second Embodiment)

FIG. 5 shows the hinge frame 111a and the first connector 131 included in the cell tray 100 according to the second exemplary embodiment of the present invention.

Referring to FIG. 5, it can be known that a single hinge frame 111a includes four hinge coupling parts S, and that four first connectors 131 are hinged to each of the hinge coupling parts S.

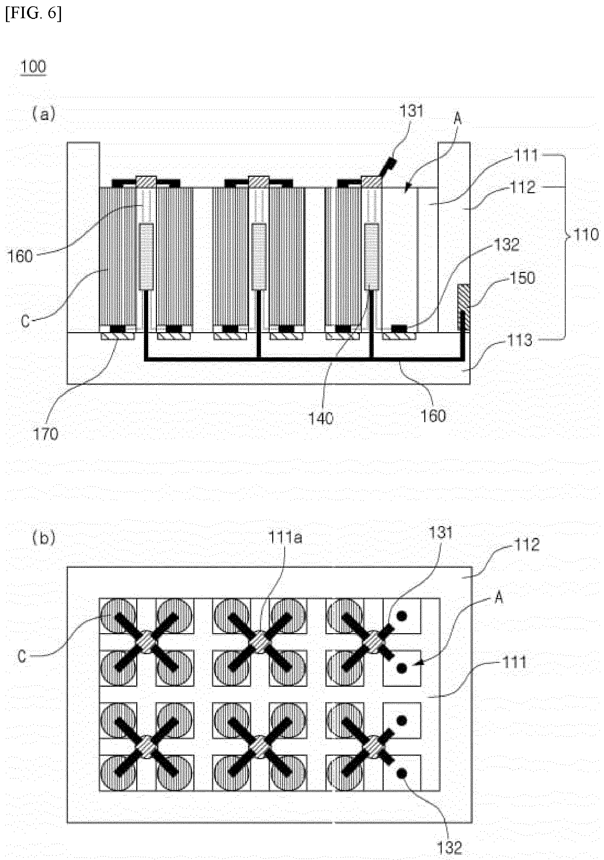

A cell tray 100 structure to which the configurations of the hinge frame 111a and the first connector 131 are applied is shown in FIG. 6.

FIG. 6 is a cross-sectional view and a plan view of a cell tray 100 according to the second exemplary embodiment of the present invention.

The hinge frame 111a has four hinge coupling parts S, and four first connectors 131 are each hinged to the hinge coupling parts S, and the hinge frame is installed so that the four hinge coupling parts S face the diagonal direction of the lattice space formed by the partition walls 111 at the upper part of the partition wall 111 at the point where the lattice partition walls 111 intersect, allowing the first connector 131 to rotate up and down in the diagonal direction of the lattice space.

Referring to FIG. 6, it can be known that the hinge frame 111a is located at the upper part of the partition wall 111, and four first connectors 131 are hinged to a single hinge frame 111a. The first connector 131, unlike the first connector 131 included in the cell tray 100 according to the first exemplary embodiment, is installed so as to hinge rotate toward the accommodating part A located in the diagonal direction.

That is, since it is designed to enable four electrical connections through a single hinge frame 111a, it can be seen that the cell tray 100 according to the second exemplary embodiment can secure more internal space of the tray body 110, and that the ease of use is better improved.

As above, the present invention has been described with reference to exemplary embodiments, but it should be understood by those killed in the art or those of ordinary skill in the art that the present invention can be variously modified and changed without departing from the technical scope of the present invention described in the accompanying claims.

### [Description of Symbols]

10: (CONVENTIONAL) MAIN BODY
11: (CONVENTIONAL) BATTERY ACCOMMODATING PART
20: (CONVENTIONAL) COVER
30: (CONVENTIONAL) CYLINDRICAL CELL
100: CELL TRAY
110: TRAY BODY
111: PARTITION WALL
111a: HINGE FRAME
111a1: GROOVE
112: OUTER FRAME
113: BOTTOM PLATE
120: TRAY TOP
121: INSULATING MEMBER
130a: HINGE SHAFT
131: FIRST CONNECTOR
132: SECOND CONNECTOR
140: ELECTRICAL CHARACTERISTIC MEASURING DEVICE
150: WIRELESS COMMUNICATION DEVICE
160: CONDUCTING WIRE
170: COOLING MEMBER
C: CYLINDRICAL CELL
A: ACCOMMODATING PART
S: HINGE COUPLING PART

## Claims

1. A cell tray (100), comprising:
a tray body (110) in which upper part is open and has a partitioning wall (111) dividing the internal space so that multiple cylindrical cells (C) are each accommodated between the partition walls (111);
a first connector (131) pivotably installed on an upper part of the partition wall (111), and pivoting toward the upper electrode tab so as to come into contact with the upper electrode tab of the cylindrical cell (C) accommodated between the partition walls (111);
a second connector (132) installed in the tray body (110) between the partition walls (111) and comes into contact with the lower electrode tab of the cylindrical cell (C) accommodated between the partition walls (111); and
an electrical characteristic measuring device (140) that is electrically connected to the first connector (131) and the second connector (132) to measure the electrical characteristics of the cylindrical cell (C).

2. The cell tray (100) of claim 1, wherein
the partition wall (111) is formed in a lattice shape.

3. The cell tray (100) of claim 2, wherein
the tray body (110) comprises a bottom plate (113) forming the lower part of the tray body (110), a lattice-type partition wall (111) installed on the bottom plate (113), and an outer frame (112) surrounding the lattice-type partition wall (111) and coupled to the bottom plate (113) or integrally formed with the bottom plate (113).

4. The cell tray (100) of claim 3, wherein
the outer frame (112) is formed higher than the height of the partition wall (111), with a height exceeding the rotation radius of the first connector (131).

5. The cell tray (100) of claim 1, wherein
a hinge frame (111a) is installed on the upper part of the partition wall (111),
and the first connector (131) has a hinge shaft (130a) hinged to the hinge frame (111a).

6. The cell tray (100) of claim 1, wherein
the electrical characteristic measuring device (140) measures at least one of the characteristics of resistance, voltage, and current of the accommodated cylindrical cell (C).

7. The cell tray (100) of claim 1, wherein
a wireless communication device (150) connected to the electrical characteristic measuring device (140) and capable of transmitting the electrical characteristic values of the cylindrical cell (C) measured by the electrical characteristic measuring device (140) to the outside is installed on the tray body (110).

8. The cell tray (100) of claim 3, wherein
a cooling member (170) for cooling the cylindrical cell (C) is installed on the bottom plate (113) of the tray body (110).

9. The cell tray (100) of claim 8, wherein
a cooling member accommodating groove is formed in the bottom plate (113) so that the cooling member (170) is installed in the cooling member accommodating groove, and the second connector (132) is installed on the cooling member (170).

10. The cell tray (100) of claim 8, wherein
the cooling member (170) is a thermoelectric module.

11. The cell tray (100) of claim 1,
further comprising a tray top (120) coupled to the tray body (110) while covering the opened upper part of the tray body (110).

12. The cell tray (100) of claim 11, wherein
the tray top (120) comprises an insulating member (121) protruding downward at a position corresponding to the cylindrical cell (C) accommodated between the partition walls (111).

13. The cell tray (100) of claim 11, wherein
the electrical characteristic measuring device (140) is installed either on the tray body (110) or on the tray top (120).

14. The cell tray (100) of claim 5, wherein
the hinge frame (111a) is hinged to multiple first connectors (131) rotating toward the upper electrode tab of the cylindrical cell (C) located in front and rear, left and right, or front, rear, left, and right of the partition wall (111).

15. The cell tray (100) of claim 14, wherein
the partition wall (111) is formed in a lattice shape;
the hinge frame (111a) has four hinge coupling parts (S), and four first connectors (131) are each hinged to the hinge coupling parts (S); and
the hinge frame (111a) is installed so that the four hinge coupling parts (S) face the diagonal direction of the lattice space formed by the partition walls (111) at the upper part of the partition wall (111) at the point where the lattice partition walls (111) intersect, allowing the first connector (131) to rotate up and down in the diagonal direction of the lattice space.

## Patentansprüche

1. Zellenträger (100) aufweisend:
einen Trägerkörper (110), bei dem ein oberer Teil offen ist und eine Trennwand (111) aufweist, die den Innenraum derart unterteilt, dass mehrere zylindrische Zellen (C) jeweils zwischen den Trennwänden (111) aufgenommen sind;
einen ersten Verbinder (131), der schwenkbar an einem oberen Teil der Trennwand (111) installiert ist und in Richtung der oberen Elektrodenlasche derart schwenkt, dass er mit der oberen Elektrodenlasche der zylindrischen Zelle (C), die zwischen den Trennwänden (111) aufgenommen ist, in Kontakt kommt;
einen zweiten Verbinder (132), der in dem Trägerkörper (110) zwischen den Trennwänden (111) installiert ist und mit der unteren Elektrodenlasche der zylindrischen Zelle (C), die zwischen den Trennwänden (111) aufgenommen ist, in Kontakt kommt; und
eine Messvorrichtung (140) für elektrische Eigenschaften, die elektrisch mit dem ersten Verbinder (131) und dem zweiten Verbinder (132) verbunden ist, um die elektrischen Eigenschaften der zylindrischen Zelle (C) zu messen.

2. Zellenträger (100) nach Anspruch 1, wobei
die Trennwand (111) in einer Gitterform ausgebildet ist.

3. Zellenträger (100) nach Anspruch 2, wobei
der Trägerkörper (110) eine Bodenplatte (113), die den unteren Teil des Trägerkörpers (110) bildet, eine gitterartige Trennwand (111), die auf der Bodenplatte (113) installiert ist, und einen äußeren Rahmen (112) aufweist, der die gitterartige Trennwand (111) umgibt und mit der Bodenplatte (113) gekoppelt oder einstückig mit der Bodenplatte (113) ausgebildet ist.

4. Zellenträger (100) nach Anspruch 3, wobei
der äußere Rahmen (112) höher als die Höhe der Trennwand (111) ausgebildet ist, wobei eine Höhe den Rotationsradius des ersten Verbinders (131) übersteigt.

5. Zellenträger (100) nach Anspruch 1, wobei
ein Scharnierrahmen (111a) an dem oberen Teil der Trennwand (111) installiert ist,
und der erste Verbinder (131) eine Scharnierwelle (130a) aufweist, die an dem Scharnierrahmen (111a) angelenkt ist.

6. Zellenträger (100) nach Anspruch 1, wobei
die Messvorrichtung (140) für elektrische Eigenschaften mindestens eine der Eigenschaften von Widerstand, Spannung und Strom der aufgenommenen zylindrischen Zelle (C) misst.

7. Zellenträger (100) nach Anspruch 1, wobei
eine drahtlose Kommunikationsvorrichtung (150), die mit der Messvorrichtung (140) für elektrische Eigenschaften verbunden ist und in der Lage ist, die elektrischen Eigenschaftswerte der zylindrischen Zelle (C), die durch die Messvorrichtung (140) für elektrische Eigenschaften gemessen werden, nach außen zu übertragen, an dem Trägerkörper (110) installiert ist.

8. Zellenträger (100) nach Anspruch 3, wobei
ein Kühlelement (170) zum Kühlen der zylindrischen Zelle (C) an der Bodenplatte (113) des Trägerkörpers (110) installiert ist.

9. Zellenträger (100) nach Anspruch 8, wobei
eine Kühlelementaufnahmenut in der Bodenplatte (113) derart ausgebildet ist, dass das Kühlelement (170) in der Kühlelementaufnahmenut installiert ist, und der zweite Verbinder (132) an dem Kühlelement (170) installiert ist.

10. Zellenträger (100) nach Anspruch 8, wobei
das Kühlelement (170) ein thermoelektrisches Modul ist.

11. Zellenträger (100) nach Anspruch 1,
ferner aufweisend eine Trägeroberseite (120), die mit dem Trägerkörper (110) gekoppelt ist, während sie den geöffneten oberen Teil des Trägerkörpers (110) abdeckt.

12. Zellenträger (100) nach Anspruch 11, wobei
die Trägeroberseite (120) ein Isolierelement (121) aufweist, das an einer Position, die der zylindrischen Zelle (C) entspricht, die zwischen den Trennwänden (111) aufgenommen ist, nach unten vorsteht.

13. Zellenträger (100) nach Anspruch 11, wobei
die Messvorrichtung (140) für elektrische Eigenschaften entweder an dem Trägerkörper (110) oder an der Trägeroberseite (120) installiert ist.

14. Zellenträger (100) nach Anspruch 5, wobei
der Scharnierrahmen (111a) an mehreren ersten Verbindern (131) angelenkt ist, die sich in Richtung der oberen Elektrodenlasche der zylindrischen Zelle (C) drehen, die sich vorne und hinten, links und rechts, oder vorne, hinten, links und rechts der Trennwand (111) befinden.

15. Zellenträger (100) nach Anspruch 14, wobei
die Trennwand (111) in einer Gitterform ausgebildet ist;
der Scharnierrahmen (111a) vier Scharnierkopplungsteile (S) aufweist, und vier erste Verbinder (131) jeweils an den Scharnierkopplungsteilen (S) angelenkt sind; und
der Scharnierrahmen (111a) derart installiert ist, dass die vier Scharnierkopplungsteile (S) der diagonalen Richtung des Gitterraums zugewandt sind, der durch die Trennwände (111) an dem oberen Teil der Trennwand (111) an dem Punkt gebildet ist, an dem sich die Gittertrennwände (111) schneiden, wodurch es dem ersten Verbinder (131) ermöglicht wird, sich in der diagonalen Richtung des Gitterraums nach oben und unten zu drehen.

## Revendications

1. Plateau de cellules (100), comprenant:
un corps de plateau (110) dont la partie supérieure est ouverte et possédant une cloison (111) divisant l'espace interne de sorte que de multiples cellules cylindriques (C) soient chacune logée entre les cloisons (111) ;
un premier connecteur (131) installé de façon pivotante sur une partie supérieure de la cloison (111), et pivotant vers la languette d'électrode supérieure afin d'entrer en contact avec la languette supérieure de la cellule cylindrique (C) logée entre les cloisons (111) ;
un deuxième connecteur (132) installé dans le corps du plateau (110) entre les cloisons (111) et entrant en contact avec la languette d'électrode supérieure de la cellule cylindrique (C) logée entre les cloisons (111) ; et
un dispositif de mesure des propriétés électriques (140) connecté électriquement au premier connecteur (131) et au deuxième connecteur (132) pour mesurer les propriétés électriques de la cellule cylindrique (C).

2. Plateau de cellules (100) selon la revendication 1,
la cloison (111) étant réalisée en forme de treillis.

3. Plateau de cellules (100) selon la revendication 2,
le corps du plateau (110) étant composé d'une plaque inférieure (113) formant la partie inférieure du corps du plateau (110), d'une cloison en treillis (111) installée sur la plaque inférieure (113), et d'un cadre extérieur (112) entourant la cloison en treillis (111) et couplée à la plaque inférieure (113) ou intégrée à la plaque inférieure (113).

4. Plateau de cellules (100) selon la revendication 3,
le cadre extérieur (112) étant formé plus haut que la hauteur de la cloison (111), sa hauteur dépassant le rayon de rotation du premier connecteur (131).

5. Plateau de cellules (100) selon la revendication 1,
un cadre articulé (111a) étant installé sur la partie supérieure de la cloison (111),
et le premier connecteur (131) possédant un axe d'articulation (130a) articulé avec le cadre articulé (111a).

6. Plateau de cellules (100) selon la revendication 1,
le dispositif de mesure des propriétés électriques (140) mesurant au moins une des propriétés de résistance, de tension et de courant de la cellule cylindrique (C) installée.

7. Plateau de cellules (100) selon la revendication 1,
un dispositif de communication sans fil (150) connecté au dispositif de mesure des propriétés électriques (140) et capable de transmettre les valeurs caractéristiques électriques de la cellule cylindrique (C), mesurées par le dispositif de mesure des propriétés électriques (140) vers l'extérieur, étant installé sur le corps du plateau (110).

8. Plateau de cellules (100) selon la revendication 3,
un élément de refroidissement (170) pour refroidir la cellule cylindrique (C) étant installé sur la plaque inférieure (113) du corps du plateau (110).

9. Plateau de cellules (100) selon la revendication 8,
une rainure réceptrice de l'élément de refroidissement étant formée dans la plaque inférieure (113) de sorte que l'élément de refroidissement (170) soit installé dans la rainure réceptrice de l'élément de refroidissement, et que le deuxième connecteur (132) soit installé sur l'élément de refroidissement (170).

10. Plateau de cellules (100) selon la revendication 8,
l'élément de refroidissement (170) étant un module thermoélectrique.

11. Plateau de cellules (100) selon la revendication 1,
comprenant en outre un dessus de plateau (120) couplé au corps du plateau (110) tout en couvrant la partie supérieure ouverte du corps du plateau (110).

12. Plateau de cellules (100) selon la revendication 11,
le dessus de plateau (120) comprenant un élément isolant (121) dépassant vers le bas dans une position correspondant à la cellule cylindrique (C) située entre les cloisons (111).

13. Plateau de cellules (100) selon la revendication 11,
le dispositif de mesure des propriétés électriques (140) étant installé soit sur le corps du plateau (110), soit sur le dessus du plateau (120).

14. Plateau de cellules (100) selon la revendication 5,
le cadre articulé (111a) étant articulé avec plusieurs premiers connecteurs (131) tournant vers la languette d'électrode supérieure de la cellule cylindrique (C) située devant et derrière, à gauche et à droite, ou devant, derrière, à gauche et à droite de la cloison (111).

15. Plateau de cellules (100) selon la revendication 14,
la cloison (111) étant réalisée en forme de treillis;
le cadre de charnière (111a) possédant quatre pièces d'accouplement de charnière (S), et quatre premiers connecteurs (131) articulés chacun aux pièces d'accouplement de charnière (S) ; et
le cadre de charnière (111a) étant installé de sorte que les quatre parties d'accouplement de charnière (S) se trouvent face à la direction diagonale de l'espace en treillis formé par les cloisons (111) sur la partie supérieure de la cloison (111), au point où les cloisons en treillis (111) se croisent, en permettant la rotation en haut et en bas du premier connecteur (131) dans la direction diagonale de l'espace en treillis.
